# EUROPEAN PATENT APPLICATION

(11) **EP 4 386 862 A1**
(43) Date of publication of application: **19.06.2024**
(21) Application number: 22213755.6
(22) Date of filing: 15.12.2022
(51) Int. Cl.: H01L 29/786, H01L 21/28, H01L 29/51, H01L 29/66, H01L 29/78

(54) **FERROELECTRIC FIELD-EFFECT TRANSISTOR MEMORY STRUCTURE**

(71) Applicant: Imec VZW, 3001 Leuven (BE)
(72) Inventor: WALKE, Amey Mahadev, 3001 Heverlee (BE); VAN HOUDT, Jan, 3460 Bekkevoort (BE)
(74) Representative: Roth, Sebastian

(57) **Abstract**

The disclosure relates to a ferroelectric field-effect transistor, FeFET, memory structure (10). The FeFET memory structure (10) comprises a substrate (11) which comprises an insulator layer (11b); a gate metal layer (13) on the insulator layer (11b); at least one ferroelectric material layer (14) on the gate metal layer (13); and a layer structure (15) comprising at least one wide bandgap semiconductor layer on the ferroelectric material layer (14), wherein the layer structure comprises: a first section (15-1) having a first height, and at least one second section (15-2) having a second height that is smaller than the first height. The FeFET memory structure (10) further comprises a drain metal structure (17) which is arranged on the first section (15-1) of the layer structure (15); and one or more source metal structures (16), wherein each source metal structure (16) is arranged on a respective second section (15-2) of the layer structure (15).

## Description

### TECHNICAL FIELD

The present disclosure relates to a ferroelectric field-effect transistor (FeFET) memory structure and to a memory device comprising such a FeFET memory structure. The present disclosure further relates to a method of fabricating a FeFET memory structure.

### BACKGROUND

A ferroelectric field-effect transistor (FeFET) is a field-effect transistor where the gate dielectric is replaced by a ferroelectric material. FeFETs can be used in memory devices, wherein data is stored in the form of a threshold voltage of the FET which depends on the net ferroelectric polarization (up or down) charge of the ferroelectric material.

FeFETs are promising candidates for non-volatile memories (NVM). They can be faster and more energy efficient than conventional flash memories. In particular, FeFETs can offer faster read/write operations of ca. 10-1000 ns, compared to ca. 100 µs in conventional flash memories, and require lower program/erase voltages which enables operation with lower energy consumption.

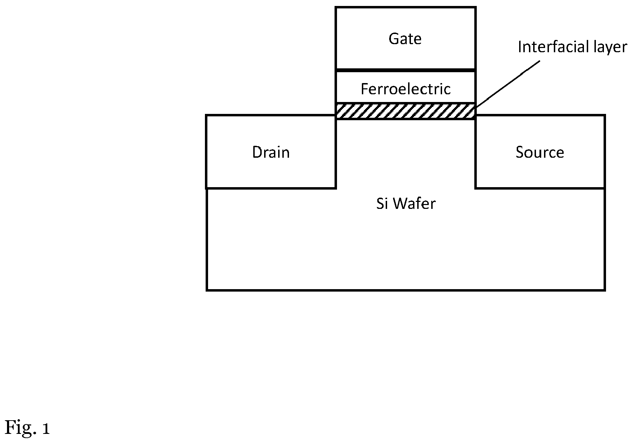

A conventional FeFET is shown in Fig. 1. The FeFET is top gated, i.e., the gate contact is arranged on top of the ferroelectric layer. This often causes the formation of an interfacial layer (e.g., SiO₂) between the channel and the ferroelectric material. The interfacial layer is typically formed as a consequence of a scavenging of oxygen by the Si channel from the oxide ferroelectric material. This interfacial layer can increase the voltages which are required for programming and can cause a favorable band alignment for charge trapping in the ferroelectric layer which can degrade the memory window leading to poor endurance and retention.

A typical NAND memory configuration comprises several such top-gated FeFET transistors which are connected in series. Thereby, the three voltage ranges V_{read}, Vₚₐₛₛ and V_{prog} are required for operation, wherein V_{read} < Vₚₐₛₛ < V_{prog}. For instance, during read operation, the cell being read receives V_{read} bias on gate and other cells in series receive Vₚₐₛₛ bias. However, if Vₚₐₛₛ is too close to V_{prog}, there is a high risk of read disturb to the cells which are not being read. This also prevents scaling down of V_{prog} bias causing a higher overall energy of operation. Furthermore, a typical NAND configuration has source and drain contacts farther away from the gates which increases the programing voltages as well as the programming time.

### SUMMARY

Thus, it is an objective to provide an improved FeFET memory structure and an improved method of fabricating a FeFET memory structure. In particular, the above-mentioned disadvantages should be avoided.

The objective is achieved by the embodiments provided in the enclosed independent claims. Advantageous implementations of the embodiments of the disclosure are further defined in the dependent claims.

According to a first aspect, the present disclosure relates to a ferroelectric field-effect transistor (FeFET) memory structure, comprising: a substrate which comprises an insulator layer; a gate metal layer on the insulator layer; at least one ferroelectric material layer on the gate metal layer; a layer structure comprising at least one wide bandgap semiconductor layer on the ferroelectric material layer. The layer structure comprises: a first section having a first height, and at least one second section having a second height that is smaller than the first height. The FeFET memory structure further comprises a drain metal structure which is arranged on the first section of the layer structure; and one or more source metal structures, wherein each source metal structure is arranged on a respective second section of the layer structure.

This achieves the advantage that a FeFET memory structure is provided that requires lower voltages during reading/writing and operates with enhanced speed compared to conventional FeFET memories.

In particular, the ferroelectric material layer of the memory structure stores information by its two net ferroelectric polarization states (up and down). Thereby, the sections of the ferroelectric material layer under each source structure can be individually programmed / read-out. This reading/writing is performed by applying appropriate voltages to the source, the gate and the drain contacts. The ferroelectric polarization state of the ferroelectric material layer (under each source) determines the local conductive state of the wide bandgap semiconductor layer and its contact resistance to the above source metal structure.

The reduced thickness of the layer structure in the second section below the source metal structure(s) can have the following advantageous effects: The thinner channel (i.e., the layer structure below the source) ensures a higher modulation of the conductivity of the channel (depending on the ferroelectric polarization) which causes a higher modulation in the contact resistance with the source contact, thus, facilitating the read-out of the memory state. Further, the reduced thickness reduces the programming voltage requirements of the ferroelectric material layer. Apart from the region below the source, the thickness of the layer structure is increased (e.g., between adjacent sources or under drain). This enhanced thickness reduces the sheet resistance of the wide bandgap semiconductor layer for horizontal currents (e.g., currents to and from the drain structure), which can enhance the speed of operation of the memory.

In particular, the wide bandgap semiconductor layer has a bandgap larger than Si. For instance, the wide bandgap semiconductor layer can be an oxide semiconductor layer (e.g., IGZO). Such oxide based semiconductor materials do not form an additional interfacial layer (e.g., a SiO₂ layer) as it often occurs in conventional FeFETs. Thus, the programming voltage does not have to be enhanced to compensate for this interface layer. Furthermore, a less favorable band alignment for chare trapping can be achieved. This prevents the drifting of the threshold voltage and, thus, improves the endurance of the device. Furthermore, the reduced charge trapping also shortens a delay to read after writing data in the memory.

The source and drain metal structures can comprise identical or different metals. The drain metal can form an ohmic contact with the first section of the layer structure, while the source metal can form a Schottky contact with the second section of the layer structure. The insulator layer preferably insulates the memory device.

In an embodiment, the first section of the layer structure has a height between 10 and 30 nm, preferably between 15 and 25 nm. This achieves the advantage of an enhanced sheet resistance of the wide bandgap semiconductor layer for horizontal currents which can enhance the speed of operation of the memory device.

In an embodiment, the at least one second section of the layer structure has a height between 2 and 8 nm, preferably between 3 and 5 nm. In particular, this reduced layer thickness below the source contacts causes a strong modulation in the contact resistance between the wide bandgap semiconductor layer and the source metal structures depending on the net polarization state of the ferroelectric In other words, the difference between the contact resistance between the polarizations "up" and "down" can be enhanced.

In an embodiment, the layer structure comprises at least one layer of any one of the following materials: indium gallium zinc oxide (IGZO) indium tin oxide (ITO), indium zinc oxide (IZO), tungsten oxide (WO), zinc oxide (ZnO), indium oxide (InO), tin oxide (SnO), magnesium zinc oxide (MgZnO), MgAl-doped ZnO (MgAlZnO), or gallium zinc oxide (GaZnO).

The layer structure can be a multilayer stack, which comprises layers of different materials and conductivities. A bottom layer of the stack (which also covers the area under the source contacts) can have a lower conductivity than the top layer(s). In particular, the layer stack can be a bilayer stack.

In an embodiment, the ferroelectric material layer comprises any one of the following materials: doped or undoped hafnium-zirconium oxide (HZO), in particular lanthanum doped HZO (La:HZO), doped hafnium oxides, complex oxides from the perovskite family, in particular SBT-SrBiTaO, PZT-PbZrTiO, BFO-BiFeO, or BTO-BaTiO, or other ferroelectrics, such as Wurtzites, in particular AlScN or MgZnO.

In an embodiment, the gate metal layer comprises any one of the following materials: titanium nitride (TiN), tungsten (W), aluminum (Al), molybdenum (Mo), doped polycrystalline silicon (poly-Si), doped germanium (Ge), platinum (Pt), or rutherfordium (Ru).

In an embodiment, the layer structure comprises a plurality of second sections which are separated from each other, and which are arranged along a line; wherein a respective source metal structure is arranged on each of the plurality of second sections.

In an embodiment, the FeFET memory structure further comprises a gate contact structure which is arranged on the gate metal layer, wherein the gate contact structure is configured to apply a voltage to the gate metal layer.

According to a second aspect, the present disclosure relates to a memory device, comprising: a plurality of FeFET memory structures according to the first aspect of the disclosure; and one or more bit line structures on the FeFET memory structures; wherein each bit line structure is in contact with one source metal structure of each of the plurality of FeFET memory structures; and wherein each bit line structure is configured to apply a voltage to the source metal structures with which it is in contact.

The gate metal layer of each FeFET memory structure can form respective word line structures of the memory device. The gate metal layers (word lines) and bit line structures can be arranged perpendicular to each other, forming a crossbar array. Thus, the memory device can be a memory array device.

In particular, the bit line structures can be arranged on the FeFET memory structures.

According to a third aspect, the present disclosure relates to a method of fabricating a ferroelectric field-effect transistor (FeFET) memory structure, comprising the steps of: forming a gate metal layer on a substrate, wherein the substrate comprises an insulating layer; forming at least one ferroelectric material layer on the gate metal layer; forming a layer structure comprising at least one wide bandgap semiconductor layer on the ferroelectric material layer, wherein the layer structure comprises: a first section having a first height, and at least one second section having a second height that is smaller than the first height. The method further comprise: forming a drain metal structure which is arranged on the first section of the layer structure; and forming one or more source metal structures, wherein each source metal structure is arranged on a respective second section of the layer structure.

In particular, the method according to the third aspect of the disclosure can be used to fabricate the FeFET memory structure according to the first aspect of the disclosure.

In an embodiment, the step of forming the layer structure comprises: forming the at least one wide bandgap semiconductor layer on the ferroelectric material layer with a uniform height, the uniform height being the first height; and locally reducing the uniform height of the at least one wide bandgap semiconductor layer to the second height to form the at least one second section.

In an embodiment, the first section of the layer structure has a height between 10 and 30 nm, preferably between 15 and 25 nm.

In an embodiment, the at least one second section of the layer structure has a height between 2 and 8 nm, preferably between 3 and 5 nm.

In an embodiment, the gate metal layer is removed in a region below the drain metal structure prior to forming the at least one ferroelectric material layer.

In an embodiment, the method further comprises: forming a gate contact structure on the gate metal layer, wherein the gate contact structure passes through a gap in the at least one ferroelectric material layer.

The above description with regard to the FeFET memory structure according to the first aspect of the disclosure is correspondingly valid for the method according to the third aspect of the disclosure.

### BRIEF DESCRIPTION OF THE DRAWINGS

Embodiments of the invention will be explained in the followings together with the figures.
- Fig. 1: shows a FeFET according to a conventional example;
- Fig. 2: shows a schematic diagram of a FeFET memory structure according to an embodiment;
- Fig. 3: shows a schematic diagram of a FeFET memory structure according to an embodiment;
- Fig. 4: shows a top view of a memory device according to an embodiment;
- Fig. 5: shows a cross-sectional view of the memory device in Fig. 4 according to an embodiment;
- Fig. 6: shows a cross-sectional view of the memory device in Fig. 4 according to an embodiment;
- Fig. 7: shows a schematic diagram of a memory device according to an embodiment;
- Fig. 8: shows a schematic diagram of a programming of a memory device according to an embodiment;
- Fig. 9: shows a schematic diagram of a programming of a memory device according to an embodiment;
- Fig. 10: shows a schematic diagram of a reading-out of a memory device according to an embodiment;
- Fig. 11: shows a schematic diagram of a block erase of a memory device according to an embodiment; and
- Figs. 12A-I: show steps of a method for fabricating a FeFET memory structure according to an embodiment.

### DETAILED DESCRIPTION OF THE PREFERRED EMBODIMENTS

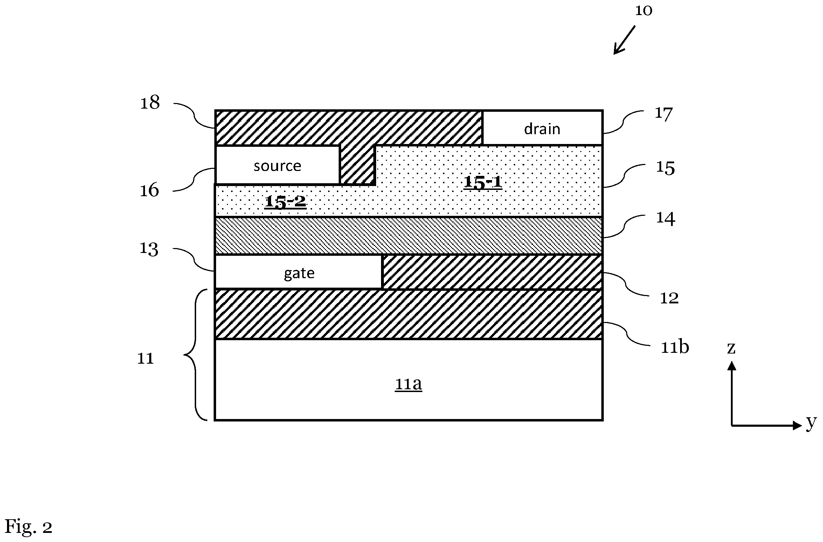

Fig. 2 shows a schematic diagram of a FeFET memory structure 10 according to an embodiment. In particular, Fig. 2 shows a cross-sectional view of the FeFET memory structure 10 across a y-z plane.

The FeFET memory structure 10 comprises a substrate 11 which comprises an insulator layer 11b. The FeFET memory structure 10 further comprises a gate metal layer 13 on the insulator layer 11b, at least one ferroelectric material layer 14 on the gate metal layer 13, and a layer structure 15 comprising at least one wide bandgap semiconductor layer. The layer structure 15 is arranged on the ferroelectric material layer 14 and comprises a first section 15-1 having a first height, and at least one second section 15-2 having a second height that is smaller than the first height. The FeFET memory structure 10 further comprises a drain metal structure 17 which is arranged on the first section 15-1 of the layer structure 15, and one or more source metal structures 16, wherein each source metal structure 16 is arranged on a respective second section 15-2 of the layer structure 15.

The ferroelectric material layer 14 can be configured to store information by its two net polarization states. Thereby, the sections of the ferroelectric material layer 14 under each source structure 16 can be individually programmed / read-out.

For instance, the ferroelectric material layer 14 may comprises any one of the following materials: doped or undoped hafnium-zirconium oxide (HZO), in particular lanthanum doped HZO (La:HZO), doped hafnium oxides, complex oxides from the perovskite family, in particular SBT-SrBiTaO, PZT-PbZrTiO, BFO-BiFeO, or BTO-BaTiO, or other ferroelectrics, such as Wurtzites, in particular AlScN or MgZnO.

The layer structure 15 on the ferroelectric material layer 14 can comprise one or more wide bandgap semiconductor layers. Preferably, each wide bandgap semiconductor layer has a bandgap larger than Si. For instance, the wide bandgap semiconductor layers can be oxide semiconductor layers (e.g., IGZO). Such oxide based semiconductor materials do not form an additional interfacial layer (e.g., a SiO₂ layer) between the channel and the ferroelectric material layer 14. Thus, the programming voltage does not have to be enhanced to compensate for this interface layer. Furthermore, a less favorable band alignment for charge trapping can be achieved. This prevents the drifting of the threshold voltage and leads to better endurance.

In particular, the memory structure 10 is a back gated FeFET where the gate is located under the source metal contact(s) 16. The layer structure 15 or parts thereof can form a channel of the FeFET memory structure 10.

The wide bandgap semiconductor material layer(s) of the layer structure 15 can comprise or be formed from any one of the following materials: indium gallium zinc oxide (IGZO) indium tin oxide (ITO), indium zinc oxide (IZO), tungsten oxide (WO), zinc oxide (ZnO), indium oxide (InO), tin oxide (SnO), magnesium zinc oxide (MgZnO), MgAl-doped ZnO (MgAlZnO), or gallium zinc oxide (GaZnO).

In particular, the (net) polarization state of the ferroelectric material layer (under each source metal structure 16) determines the local conductive state of the wide bandgap semiconductor layer(s) and its contact resistance to the above source metal structure 16, which can be utilized to read-out the ferroelectric polarization and, thus, memory state.

For instance, the height of the first section 15-1 of the layer structure 15 (i.e., the first height) is between 10 and 30 nm, preferably between 15 and 25 nm, and the height of the at least one second section 15-2 of the layer structure 15-2 (i.e., the second height) is between 2 and 8 nm, preferably between 3 and 5 nm.

In particular, the ferroelectric material layer 14 has a bigger thickness than the layer structure 15, in particular than the second section 15-2 of the layer structure 15. This can ensure a stronger potential drop across the ferroelectric material layer 15.

In particular, the reduced thickness of the layer structure 15 below the source metal structure(s) 16 increases the modulation of the conductivity of the channel. The higher conductivity modulation ensures a higher modulation in the contact resistance between the layer structure 15 and the source metal structure 16 which can be used to measure the polarization state of the ferroelectric. Furthermore, the reduced thickness reduces programming voltage requirements of the ferroelectric material layer.

The increased thickness of the layer structure 15 in the first section 15-1 can reduce the sheet resistance of the wide bandgap semiconductor layer(s) for horizontal currents (e.g., current to and from the drain metal structure 17).

The insulator layer 11b preferably helps to insulate the memory structure 10. The insulator layer 11b can be an oxide. The substrate 11 may further comprise a base substrate 11a, e.g. silicon wafer or a part thereof, wherein the insulator layer 11b is arranged on the base substrate 11a.

The memory structure 10 may comprise a further oxide layer 12 which can be arranged on the insulator layer 11b in regions that are not covered by the gate metal layer 13, in particular under the first section of the layer structure 15. An additional oxide layer 18 or other isolating layer can be arranged above the layer structure 15.

The layer structure 15 can be a single layer which is structured to have the first section 15-1 with the first height and the second section 15-2 with the second height.

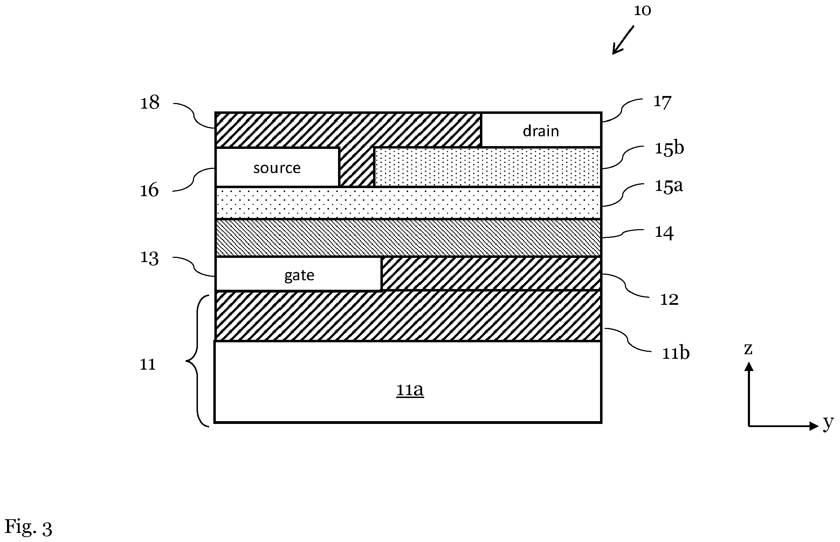

Alternatively, as shown in Fig. 3, the layer structure can be a multilayer stack, e.g. a bilayer stack. In this case, the layer structure 15 can comprise a bottom layer 15a which has the second height, and at least one further layer 15b on the bottom layer, wherein the further layer partially covers the bottom layer 15a to form the second sections 15-2 of the layer stack 15. The combined thickness of the bottom layer 15a and the further layer 15b can thereby correspond to the second height.

For instance, the source metal structure 16 can contact the bottom layer 15a which has a lower conductivity to ensure a higher modulation of its conductivity as a function of the ferroelectric polarization. The further layer 15b on the top which is in contact with the drain metal structure 17 can have a higher conductivity to ensure that the sheet resistance of the further layer 15b and the contact resistance to the drain metal structure 17 is lower.

The source and drain metal structures 16, 17 can comprise identical or different metals. For instance, the drain metal structure 17 forms an ohmic contact with the layer structure 15, while the source metal structure 16 forms a Schottky contact with the layer structure 15

The gate metal layer 13 can comprises any one of the following materials: titanium nitride (TiN), tungsten (W), aluminum (Al), molybdenum (Mo), doped polycrystalline silicon (poly-Si), doped germanium (Ge), platinum (Pt), or rutherfordium (Ru).

In particular, the gate metal layer forms a word line structure and the source metal structures 16 are connected to a bit line (not shown in Figs 2 and 3).

The layer structure 15 may comprises a plurality of second sections which are separated from each other, and which are arranged along a line. A respective source metal structure 16 can be arranged on each of the plurality of second sections.

Programming of the memory structure 10 can be performed by applying a positive respectively negative bias between the gate and source metal structures 13, 16 (MFSM capacitor). The drain metal structure 17 can be used to pump current through the bit line while reading the memory state.

In particular, after programming, the net programmed polarization state of the ferroelectric material layer 14 influences both the channel (i.e., the section of the layer structure 15 under the source) as well as the source contact resistance thereby regulating the magnitude of the current flowing through the source metal structure 16 to the bit line. For instance, if the channel is in depletion, the contact resistance between source metal structure 16 and layer structure 15 will be higher and a lower current flows though the source metal structure 16 to the bit line. If the channel is in accumulation, the contact resistance between source metal structure 16 and layer structure 15 will be lower and a higher current flows though the source metal structure 16 to the bit line.

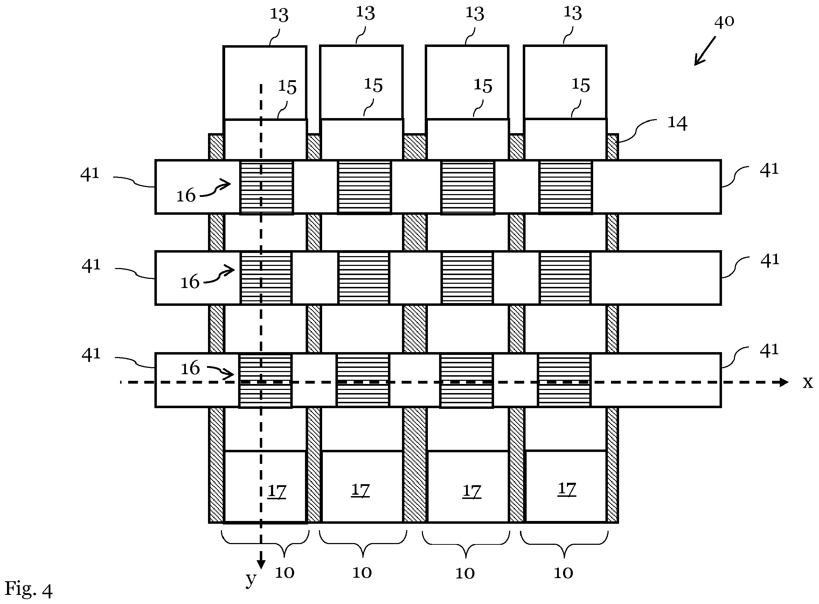

Fig. 4 shows a top view of a memory device 40, in particular a memory array device, according to an embodiment.

The memory device 40 comprises a plurality of FeFET memory structures 10, e.g. as shown in Figs. 2 or 3. The memory device 40 further comprises one or more bit line structures 41, wherein each bit line structure 41 is in contact with one source metal structure 16 of each of the plurality of FeFET memory structures 10, and wherein each bit line structure 41 is configured to apply a voltage to the source metal structures 16 to which it is in contact.

The memory device 40 can comprise a cross bar array, wherein the FeFET memory structures 10 are arranged in vertical columns and the bit line structures 41 are arranged in horizontal rows. Thus, the memory device 40 can be a memory array device. Each memory structures 10 in the example depicted in Fig. 4 comprises three source metal structures 16 which are arranged along a line and which are in contact with a respective bit line structure 41. Thereby, the gate metal layer 13 of each memory structure 10 can form a respective word line. Each word line comprises a separate drain metal contact 17 which is connected to the layer structure 15 (e.g., an IGZO layer). Below the source metal structures 16, the layer structure 15 has the (reduced) second height, wherein in the regions between the individual source metal structures 16, the layer structure 15 has the first height.

The bit line structures 41 can be connected to one or more sense amplifiers. Preferably, the memory device 40 can be operated with a unipolar power supply.

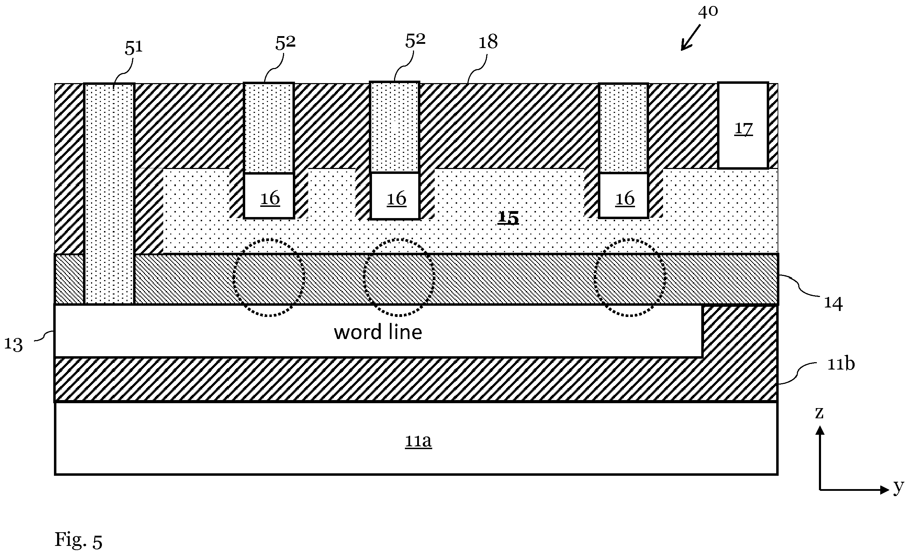

Fig. 5 shows a cross-sectional view of the memory device 40 in Fig. 4 according to an embodiment. In particular, Fig. 5 shows a cross-sectional view along a word line (y-direction) as indicated by the vertical dashed line in Fig. 4.

As shown in Fig. 5, the memory array device 40 may comprises a gate contact structure 51 which is arranged to establish an electrical contact to the gate metal layer 13 (word line) for applying voltages to the gate metal layer 13. The memory device may further comprise bit line contacts 52 which electrically connect the source metal structures 16 to the bit line 41.

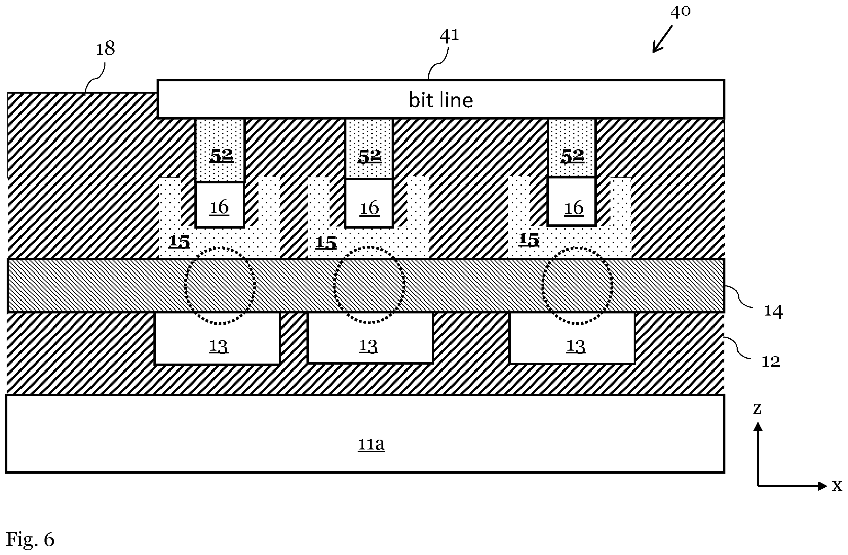

Both channel conductivity and source contact resistance can be modulated by programming the ferroelectric material layer 14, e.g. a HZO layer. The ferroelectric material layer 14 is preferably programmed in the regions below the source metal structures 16 (highlighted by the dashed circles in Figs. 5 and 6). In this way, a more efficient programming can be achieved between source structures 16 and the gate layer 13 due to vertical electric fields in these regions.

Fig. 6 shows a cross-sectional view of the memory device 40 in Fig. 4 according to an embodiment. In particular, Fig. 6 shows a cross-sectional view along a bit line (x-direction) as indicated by the horizontal dashed line in Fig. 4.

The proposed design of the memory device 40 has several advantages over conventional FeFET memories: 1) The regions of the ferroelectric layer (e.g undoped or doped HZO) under the source metal structures 16 can be selectively programmed by applying a programming voltage directly between the bit lines (via source metal structures 16) and word line (gate metal layer 13); this allows for a more efficient programming as compared to programming the entire ferroelectric layer or a longer section thereof. 2) The use of a wide bandgap materials, in particular oxides, as channel material can prevent formation of interfacial oxides which allows for lower programming voltages and causes a lower charge trapping and, thus, higher endurance. 3) Both channel and contact resistance can be modulated. 4) The memory device 40 can be used as a random access memory (RAM). 5) A read disturb can be minimized or prevented by using the separate drain metal contacts 17. 6) The wide bandgap semiconductors used for the layer structure 15 can offer a very large variation in the Schottky barrier height. 7) The memory cell does not have to rely on availability of the minority carriers. Absence of minority carrier can help to increase the contact resistance ratio between a program and an erase state. 8) The drain metal contact 17 is common for a string. Thus, better area efficiency as compared to a typical NOR transistor can be achieved.

In addition, a memory cell density can be increased by sequential stacking of layers of memory devices 40. All processing steps to fabricate the memory device 40 can have a low enough thermal budget compatible with BEOL (back end of line) processing.

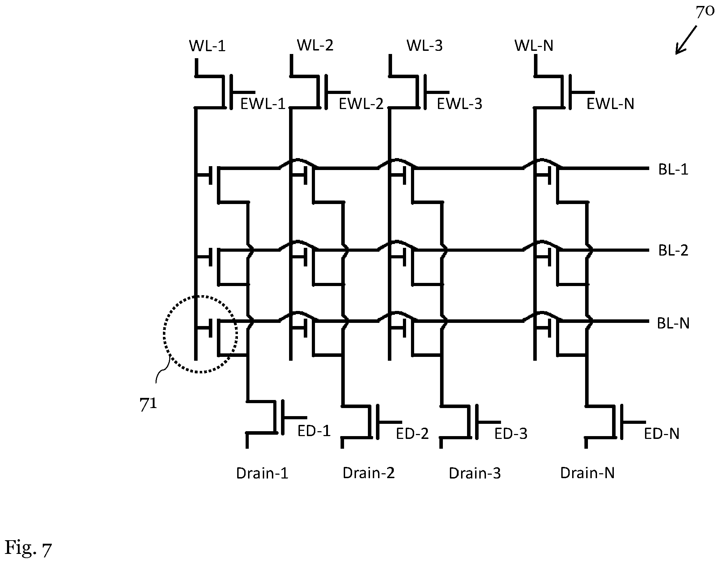

Fig. 7 shows a schematic diagram of a memory device 70 according to an embodiment. In particular, Fig. 7 shows an example of an equivalent circuit of a memory array device 40 as depicted in Figs. 4-6 with N word lines, N bit lines and N drain lines.

Each word line WL-1...N can comprise a word line enable gate EWL-1...N, such as a complementary pass transistors (e.g., NMOS+PMOS). Likewise, each drain line Drain-1...N can comprise a drain line enable gate ED-1...N, such as a complementary pass transistors (e.g., NMOS+PMOS). The word line enable gates EWL-1...N and the drain line enable gates ED-1...N can selectively activate the respective word lines WL-1...N respectively drain lines Drain-1...N.

Each memory cell 71 of the memory array device 70 can comprise a source metal structure 16 connected to a word line of the memory device and a section of the gate layer 13 below the source metal structure 16 connected to a bit line, wherein the ferroelectric material layer 14 and the layer structure 15 are arranged between source metal structure 16 and gate layer 13. Each bit line BL-1...N can be further connected to a sense amplifier.

Preferably, the memory array 70 can be operated in two modes: 1) random access, e.g. for non-volatile DRAM; and 2) block erase, e.g. for storage class NVM.

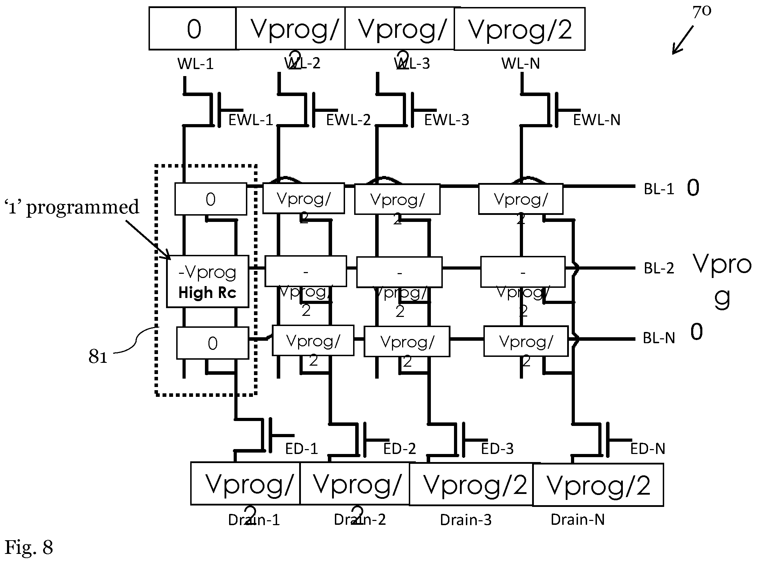

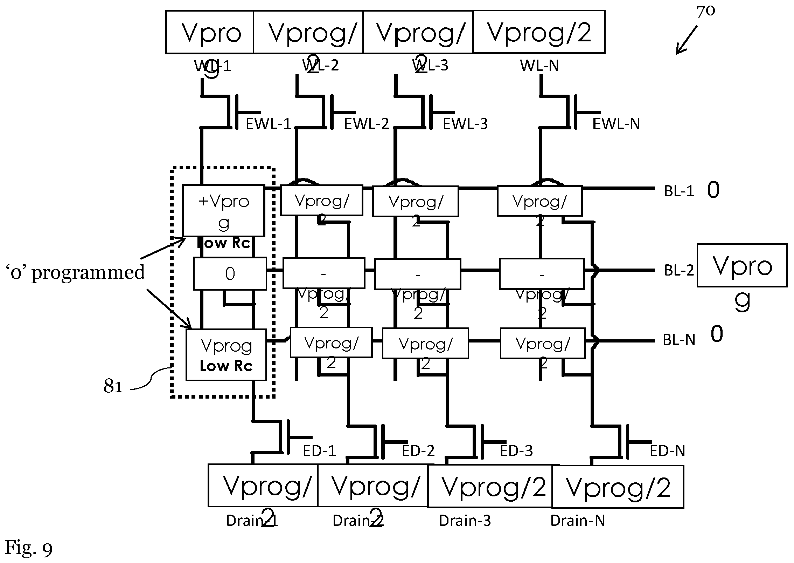

Figs. 8 and 9 show schematic diagram of programming a string 81 of the memory array device 70 according to an embodiment. In particular, Figs. 8 and 9 show a random access write operation.

In particular, the programming of the string 81 is a two-step operation: In a first step, shown in Fig. 8, the bit cells with data '1' are written in the selected string 81 (in Fig. 8, the center bit cell of the string 81). In a second step, shown in Fig. 9, the data 'o' is written in the remaining bit cells of the string 81. This scheme allows for selective write operation.

For example, during writing, all non-selected word lines and all drains are set to V_{prog/2}, and each bit line potential is set to either o V (to write 'o') or V_{prog} (to write '1'). To first program a '1' in the center memory cell of the string 81, the selected WL-1 is set to o V (cf., Fig. 8). This will write '1' across all the cells which have '-V_{prog}' voltage across the gate and the bit line (V_{gs} = - V_{prog}). To subsequently program a 'o' in the remaining cells of the string 81, the word line potential of WL-1 is changed to V_{prog} (cf., Fig. 9). This will write 'o' into the cells that have '+V_{prog}' across the gate and the bit line (V_{gs} = + V_{prog}).

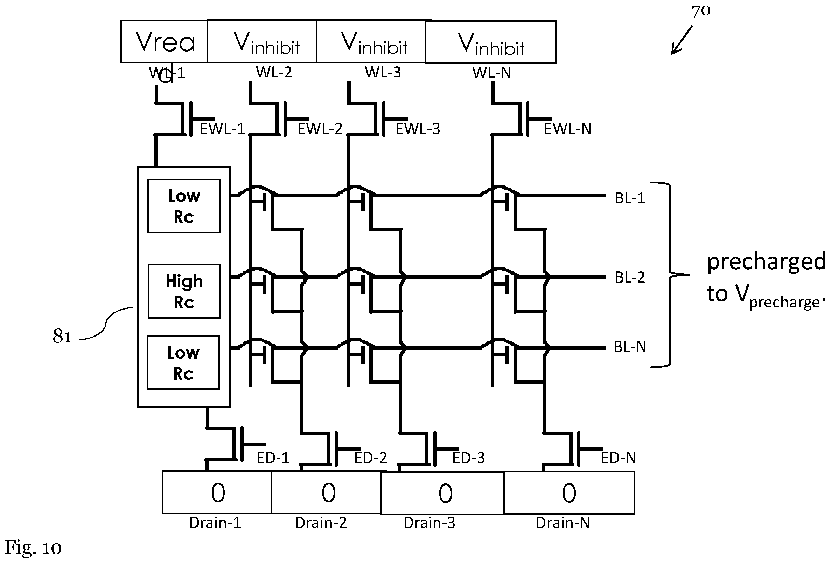

Fig. 10 shows schematic diagram of a read-out of the string 81 of the memory array device 70 according to an embodiment. In particular, Fig. 10 show a random access read operation.

The read sequence can be as follows: At first, the bit lines BL-1...N are precharged to a precharge voltage V_{precharge} which is higher than a reference voltage V_{ref} of the sense amplifier. The selected word line voltage of WL-1 is set to V_{read}, with |V_{read} |<|V_{Prog}|. Non-selected WL are set to V_{inhibit}. The voltage V_{inhibit} will push the non-selected cells into depletion, thereby suppressing the read disturb. (|V_{inhibit} |< |V_{prog}|). All drain voltages are set to o V. In particular, the non-selected drain lines can be first precharged to o V and then be disabled through the pass transistors ED-2...N to reduce interference from non-selected cells. The pass transistor ED-1 of the selected drain line can be enabled. The bit lines BL-1...N will discharge through the selected cells of the string 81. In particular, the rate of the discharging of the bit line capacitor will be governed by an Rc time constant of the contact resistance (R_{c}) of the selected memory cell and the capacitance of the bit line (C_{BL}).

In particular, the cells with lower contact resistance ('o' programmed) will discharge the bit line capacitance faster compared to the cells with higher contact resistance ('1' programmed). The sense amplifier(s) can sample the voltage on the bit lines after a fixed delay. If the voltage on a bit line (V_{bitline}) is larger than a reference voltage (V_{ref}), then the stored data is '1' else it is `o'.

In particular, depending on the contact resistance in a memory cell, a higher or lower current will flow through the source contact to the bit line.

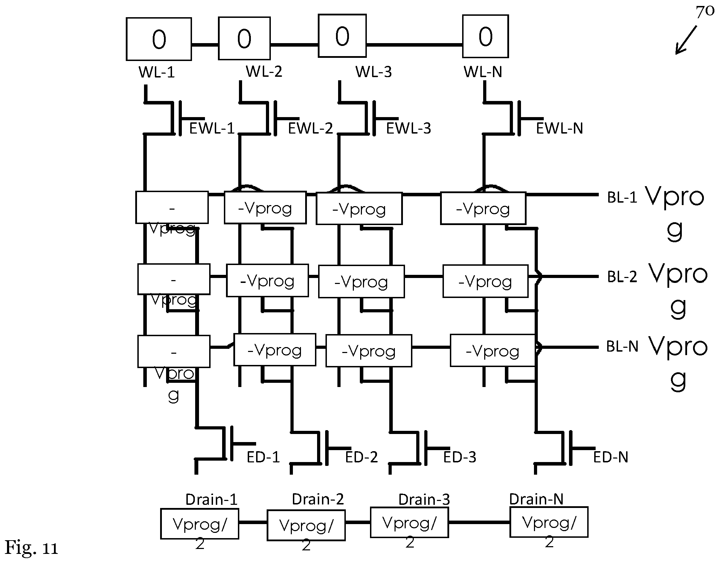

Fig. 11 shows schematic diagram of a block erase of the memory device according to an embodiment.

Preferably, during block erase, all strings of the memory device are selected and a '1' is written into an entire block of memory cells. Therefore, all word lines WL-1...N are set to o V and all bit lines BL-1...N are set to V_{prog}. The voltage across the gate and the bit line of all memory cells is set to -V_{prog} (V_{gs} = - V_{prog}).

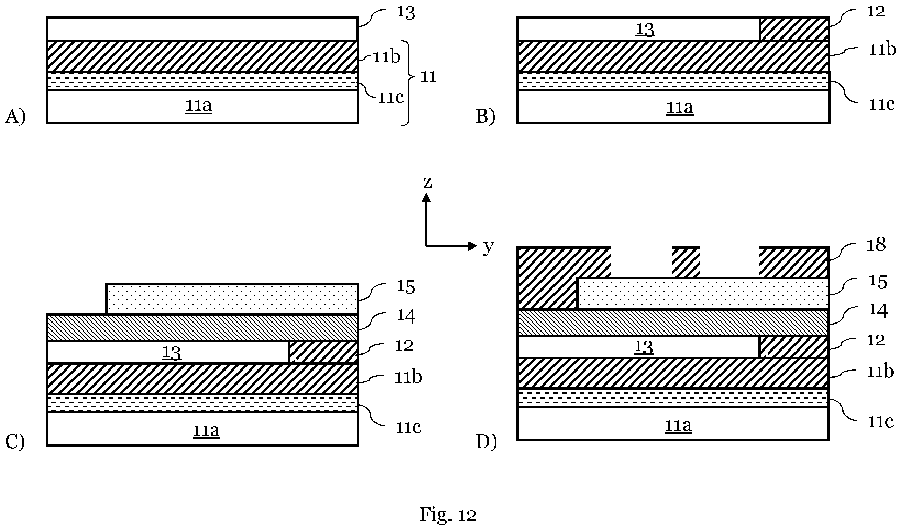

Figs. 12A-I show steps of a method for fabricating a FeFET memory structure 10 according to an embodiment. In particular, the method can be used to fabricate a FeFET memory structure 10 as shown in any one of Figs. 2-6.

The method comprises, as shown in FIG. 12A, forming the gate metal layer 13 on the substrate 11. For instance, the gate metal layer 13 can be formed from a word line metal, e.g. TiN.

The substrate 11 comprises an insulating layer 11b. Preferably, the gate metal layer 13 is formed on the insulating layer 11b. The substrate 11 may further comprise a base layer or base substrate 11a, e.g., a silicon wafer or a part thereof. The insulator layer 11b can be an oxide, e.g. a silicon oxide, and can be deposited on the base layer 11a.

The substrate 11 can further comprise a FEOL layer 11c. The FEOL layer 11c can comprise a control circuitry for memory operation, which is, e.g., first fabricated on the base layer 11a. This allows integrating the FeFET memory structure 10 in a BEOL (back end of line) stack as all processes can be compatible to a BEOL thermal budget.

In a second step, shown in Fig. 12B, the gate metal layer 13 can be selectively removed in a region that will be below the drain metal structure 17. A further oxide layer 12 can be formed on the insulator layer 11b in regions where the gate metal layer 13 was removed. The insulator layer 11b and the further oxide layer 12 can be formed from the same material. Selectively removing the back gate in this way can prevent a high parasitic capacitance and, thus, can make the memory structure 10 more energy efficiency.

In a further step, shown in Fig. 12C, the at least one ferroelectric material layer 14 is formed on the gate metal layer 13. Furthermore, at least one wide bandgap semiconductor layer of the layer structure 15 is formed on the ferroelectric material layer 14. In particular, the at least one wide bandgap semiconductor layer is formed with a uniform height, the uniform height being the first height

The ferroelectric material layer can be La doped HZO. The wide bandgap semiconductor layer can comprise an IGZO layer and can form a channel. An optional annealing step in an O₂ ambient can be carried out to modulate the conductivity of the channel (in case of an IGZO channel).

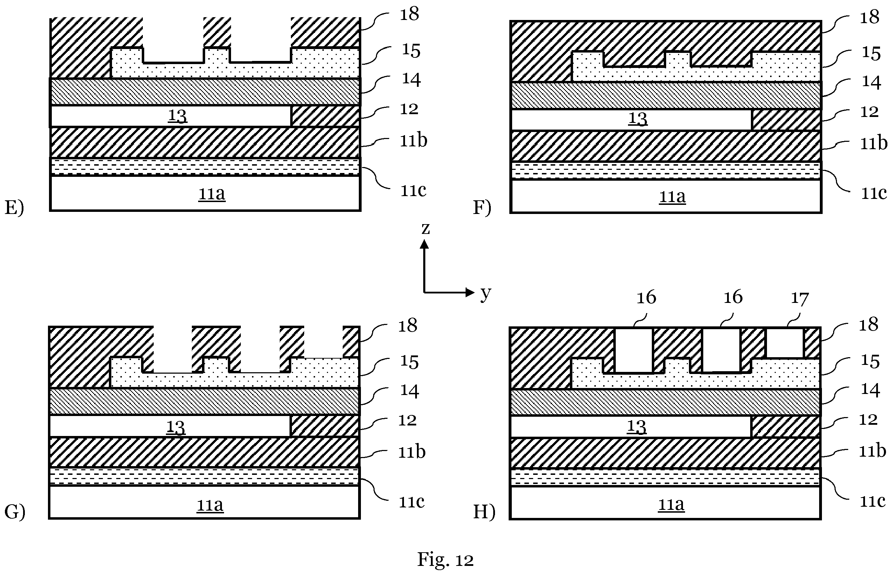

The layer structure can then be further processed by locally reducing the uniform height of the at least one wide bandgap semiconductor layer to the second height to form the at least one second section, as shown in Figs. 1D and 1E. To structure the layer structure 15 in this way, an isolating dielectric 18 or other suitable auxiliary layer can be deposited on the layer structure 15 and can be patterned to open windows for thinning down the layer structure 15 (cf., Fig. 12D), e.g. by means of suitable lithographic and/or etching steps. Subsequently, the layer structure 15 itself can be selectively thinned down to form the second sections 15-2 with reduced height (cf., Fig. 12E), e.g. by means of etching. The isolating dielectric layer 18 can be an oxide layer.

Alternatively, the layer structure 15 can comprise multiple wide bandgap semiconductor layers 15a, 15b which are arranged in the form of a layer stack, as schematically depicted in Fig. 3. These layers 15a, 15b can be selectively deposited on top of each other to form the first and second sections of the layer structure 15.

For instance, the first section of the layer structure 15 has a height between 10 and 30 nm, preferably between 15 and 25 nm, and the at least one second section of the layer structure 15 has a height between 2 and 8 nm, preferably between 3 and 5 nm.

In subsequent steps, shown in Figs. 12F to 12G, the drain metal structure 17 is formed on the first section of the layer structure 15, and the one or more source metal structures 16 are formed on respective second sections of the layer structure 15.

Therefore, the windows in the isolating dielectric 18 can be filled by depositing an additional isolation dielectric (cf., Fig. 12F). A chemical mechanical polishing (CMP) can subsequently be performed on the layer 18.

Subsequently, new windows can be opened in the layer 18 (cf., Fig. 12G), e.g. by means of a suitable lithographic technique, and the windows can be filled with source respectively drain metals (cf., Fig. 12H). A subsequent CMP step and/or annealing step to modify the conductivity of the IGZO layer can be carried out.

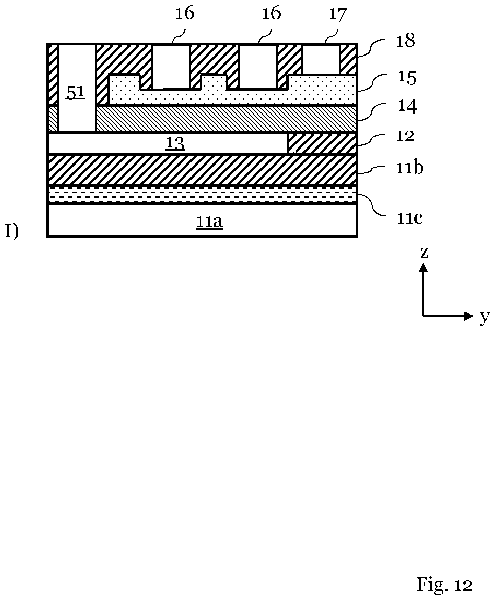

In a further step, shown in Fig. 12I, a gate contact structure 51 can be formed on the gate metal layer 13, wherein the gate contact structure 51 passes through a gap in the at least one ferroelectric material layer 14. For instance, the gate contact structure 51 is formed. by etching a window in the isolating dielectric 18 and the ferroelectric material layer 14 and filling said window with a metal.

## Claims

1. A ferroelectric field-effect transistor, FeFET, memory structure (10), comprising:
a substrate (11) which comprises an insulator layer (11b);
a gate metal layer (13) on the insulator layer (11b);
at least one ferroelectric material layer (14) on the gate metal layer (13);
a layer structure (15) comprising at least one wide bandgap semiconductor layer on the ferroelectric material layer (14), wherein the layer structure comprises:
- a first section (15-1) having a first height, and
- at least one second section (15-2) having a second height that is smaller than the first height;
a drain metal structure (17) which is arranged on the first section (15-1) of the layer structure (15); and
one or more source metal structures (16), wherein each source metal structure (16) is arranged on a respective second section (15-2) of the layer structure (15).

2. The FeFET memory structure (10) of claim 1,
wherein the first section (15-1) of the layer structure (15) has a height between 10 and 30 nm, preferably between 15 and 25 nm.

3. The FeFET memory structure (10) of claim 1 or 2,
wherein the at least one second section (15-2) of the layer structure (15) has a height between 2 and 8 nm, preferably between 3 and 5 nm.

4. The FeFET memory structure (10) of any one of the preceding claims,
wherein the layer structure (15) comprises at least one layer of any one of the following materials:
- indium gallium zinc oxide, IGZO,
- indium tin oxide, ITO,
- indium zinc oxide, IZO,
- tungsten oxide, WO,
- zinc oxide, ZnO,
- indium oxide, InO,
- tin oxide, SnO,
- magnesium zinc oxide, MgZnO
- MgAl-doped ZnO, MgAlZnO, or
- gallium zinc oxide, GaZnO.

5. The FeFET memory structure (10) of any one of the preceding claims,
wherein the ferroelectric material layer (14) comprises any one of the following materials:
- doped or undoped hafnium-zirconium oxide, HZO, in particular lanthanum doped HZO, La:HZO,
- doped hafnium oxides,
- complex oxides from the perovskite family, in particular SBT-SrBiTaO, PZT-PbZrTiO, BFO-BiFeO, or BTO-BaTiO, or
- other ferroelectrics, such as Wurtzites, in particular AlScN or MgZnO.

6. The FeFET memory structure (10) of any one of the preceding claims,
wherein the gate metal layer (13) comprises any one of the following materials:
- titanium nitride, TiN,
- tungsten, W,
- aluminum, Al,
- molybdenum, Mo,
- doped polycrystalline silicon, poly-Si,
- doped germanium, Ge,
- platinum, Pt, or
- rutherfordium, Ru.

7. The FeFET memory structure (10) of any one of the preceding claims,
wherein the layer structure (15) comprises a plurality of second sections (15-2) which are separated from each other, and which are arranged along a line; and
wherein a respective source metal structure (16) is arranged on each of the plurality of second sections (15-2).

8. The FeFET memory structure (10) of any one of the preceding claims, further comprising:
a gate contact structure (51) which is arranged on the gate metal layer (13), wherein the gate contact structure (51) is configured to apply a voltage to the gate metal layer (13).

9. A memory device (40), comprising:
a plurality of FeFET memory structures (10) of any one of the preceding claims; and
one or more bit line structures (41);
wherein each bit line structure (41) is in contact with one source metal structure (16) of each of the plurality of FeFET memory structures (10); and
wherein each bit line structure (41) is configured to apply a voltage to the source metal structures (16) with which it is in contact.

10. A method of fabricating a ferroelectric field-effect transistor, FeFET, memory structure (10), comprising the steps of:
forming a gate metal layer (13) on a substrate (11), wherein the substrate (11) comprises an insulating layer (11b);
forming at least one ferroelectric material layer (14) on the gate metal layer (13);
forming a layer structure (15) comprising at least one wide bandgap semiconductor layer on the ferroelectric material layer (14), wherein the layer structure (15) comprises:
- a first section (15-1) having a first height, and
- at least one second section (15-2) having a second height that is smaller than the first height;
forming a drain metal structure (17) which is arranged on the first section (15-1) of the layer structure (15); and
forming one or more source metal structures (16), wherein each source metal structure (16) is arranged on a respective second section (15-2) of the layer structure (15).

11. The method of claim 10, wherein the step of forming the layer structure (15) comprises:
forming the at least one wide bandgap semiconductor layer on the ferroelectric material layer (14) with a uniform height, the uniform height being the first height; and
locally reducing the uniform height of the at least one wide bandgap semiconductor layer to the second height to form the at least one second section (15-2).

12. The method of claim 10 or 11,
wherein the first section (15-1) of the layer structure (15) has a height between 10 and 30 nm, preferably between 15 and 25 nm.

13. The method of any one of claims 10 to 12,
wherein the at least one second section (15-2) of the layer structure has a height between 2 and 8 nm, preferably between 3 and 5 nm.

14. The method of any one of claims 10 to 13,
wherein the gate metal layer (13) is removed in a region below the drain metal structure (17) prior to forming the at least one ferroelectric material layer (14).

15. The method of any one of claims 10 to 14, further comprising:
forming a gate contact structure (51) on the gate metal layer (13), wherein the gate contact structure (51) passes through a gap in the at least one ferroelectric material layer (14).
